# EUROPEAN PATENT APPLICATION

(11) **EP 4 527 788 A1**
(43) Date of publication of application: **26.03.2025**
(21) Application number: 23806711.0
(22) Date of filing: 27.04.2023
(51) Int. Cl.: B81B 7/00, B81C 1/00, H01L 23/522

(54) **MICRO ELECTRO MECHANICAL SYSTEMS (MEMS) SENSOR AND PREPARATION METHOD THEREFOR**

(30) Priority: 16.05.2022 CN 202210529253
(71) Applicant: Memsensing Microsystems (Suzhou, China) Co. Ltd, Suzhou, Jiangsu 215123 (CN)
(72) Inventor: AN, Lijia, Suzhou, Jiangsu 215123 (CN)
(74) Representative: Nederlandsch Octrooibureau
(86) International application number: PCT/CN2023/091060
(87) International publication number: WO 2023/221759

(57) **Abstract**

Disclosed are a MEMS sensor and a preparation method therefor. The sensor comprises a device and a cap, wherein the device comprises a grounding electrode; and a functional layer, wherein the functional layer is electrically connected to the grounding electrode. The cap comprises: a second substrate; a second dielectric layer, which is located on a first surface of the second substrate; and a third conductive layer, which is located on the surface of the second dielectric layer that is away from the second substrate, wherein at least part of the third conductive layer penetrates the second dielectric layer to be electrically connected to the second substrate; and the surface of the third conductive layer that is away from the second dielectric layer is bonded with the functional layer, and the second substrate is electrically connected to the grounding electrode by means of the third conductive layer and the functional layer. By means of the MEMS sensor and the preparation method therefor in the present invention, batch grounding of the MEMS sensor is realized.

## Description

### CROSS-REFERENCE TO RELATED APPLICATIONS

This application claims the benefit of China Patent Application No. 202210529253.2, filed with the China National Intellectual Property Administration on May 16th, 2022 and entitled "MICRO ELECTRO MECHANICAL SYSTEMS (MEMS) SENSOR AND PREPARATION METHOD THEREFOR", the disclosures of which are incorporated by reference herein in their entirety.

### TECHNICAL FIELD

The present invention relates to the technical field of semiconductors, and more specifically, to a micro-electro-mechanical system sensor and a preparation method thereof.

### BACKGROUND

Sensors manufactured based on Micro Electro Mechanical Systems (MEMS) are called MEMS sensors. MEMS sensors have attracted much attention due to their extremely small size and good performance.

MEMS sensors usually need to be grounded to maintain shielding to prevent electromagnetic radiation and static electricity accumulation from causing fatal damage to the device. The conventional grounding method of MEMS sensors is to connect to the PCB during the packaging stage through deposition of electrode metal, wire bonding, etc. to achieve the grounding of the MEMS sensor. However, this method is complicated and less reliable, which has a negative impact on the improvement of mass production efficiency and cost reduction.

### TECHNICAL ISSUES

Embodiments of the present application provide a micro-electro-mechanical system sensor and a preparation method thereof for solving a technical issue of how to achieve bulk grounding of the MEMS sensor, and improving the shielding performance of the MEMS sensor.

### TECHNICAL SOLUTIONS

Embodiments of the present application provide a micro-electro-mechanical system sensor and a preparation method thereof.

In a first aspect, embodiments of the present application provide a micro-electro-mechanical system sensor, wherein the micro-electro-mechanical system sensor comprises a device wafer and a cap wafer, wherein the device wafer comprises:
a ground electrode;
a functional layer, the functional layer is electrically connected to the ground electrode;
the cap wafer comprises:
   a second substrate;
   a second dielectric layer, disposed on a first surface of the second substrate; and
   a third conductive layer, disposed on a surface of the second dielectric layer away from the second substrate, at least a portion of the third conductive layer passes through the second dielectric layer to be electrically connected to the second substrate;
   a surface of the third conductive layer away from the second dielectric layer is bonded to the functional layer, the second substrate is electrically connected to the ground electrode through the third conductive layer and the functional layer.

In some embodiments, the second dielectric layer comprises a through hole, the through hole exposes the first surface of the second substrate; the third conductive layer fills the through hole and is electrically connected to the second substrate through the through hole.

In some embodiments, the cross-sectional shape of the through hole is any one of circular, elliptical, polygonal, annular and irregular shapes.

In some embodiments, the device wafer comprises a second conductive layer, the second conductive layer is located between the ground electrode and the functional layer, and is electrically connected to the ground electrode and the functional layer, respectively.

In some embodiments, the device wafer comprises:
a first substrate;
a first dielectric layer disposed on the first substrate;
a first lead, is embedded within the first dielectric layer and passes through the thickness direction of the first dielectric layer;
the ground electrode is disposed on a surface of the first dielectric layer away from the first substrate, and is electrically connected to the first substrate through the first lead.

In some embodiments, the functional layer is a monocrystalline silicon layer, and the third conductive layer is a polycrystalline silicon layer.

In a second aspect, embodiments of the present application provide a preparation method of a micro-electro-mechanical system sensor, wherein the method comprises:
forming a device wafer, the device wafer comprises a ground electrode and a functional layer electrically connected to the ground electrode;
forming a second dielectric layer on a first surface of a second substrate;
forming a third conductive layer on a surface of the second dielectric layer away from the second substrate, at least a portion of the third conductive layer passes through the second dielectric layer to be electrically connected to the second substrate; and
bonding the third conductive layer with the functional layer, the second substrate is electrically connected to the ground electrode through the third conductive layer and the functional layer.

In some embodiments, before forming the third conductive layer, the method comprises forming a through hole in the second dielectric layer, the through hole exposes the first surface of the second substrate, the third conductive layer fills the through hole and is electrically connected to the second substrate through the through hole.

In some embodiments, the cross-sectional shape of the through hole is any one of circular, elliptical, polygonal, annular and irregular shapes.

In some embodiments, the method of forming the device wafer comprises forming a second conductive layer between the ground electrode and the functional layer, the second conductive layer is electrically connected to the ground electrode and the functional layer respectively.

In some embodiments, the method of forming the device wafer comprises:
forming a first dielectric layer on the first substrate;
forming a first lead, the first lead is embedded within the first dielectric layer and passes through the thickness direction of the first dielectric layer;
forming the ground electrode on a surface of the first dielectric layer away from the first substrate, the ground electrode is electrically connected to the first substrate through the first lead.

In some embodiments, the functional layer is a monocrystalline silicon layer, and the third conductive layer is a polycrystalline silicon layer.

In some embodiments, the method of bonding the third conductive layer with the functional layer comprises:
performing wet activation on the surfaces of the functional layer and the third conductive layer;
pre-bonding the functional layer with the third conductive layer;
annealing the cap wafer and device wafer fitted together.

In some embodiments, in the step of performing wet activation of the surfaces of the functional layer and the third conductive layer, an oxide layer is respectively formed on the surfaces of the functional layer and the third conductive layer.

In some embodiments, the thickness of the oxide layer is less than 5 angstroms.

In some embodiments, during the process of annealing the cap wafer and device wafer fitted together, the annealing temperature is 900°C~1200°C, the annealing time is 20min~50min.

In some embodiments, the oxide layer is respectively formed on the surface of the functional layer and the third conductive layer, and the thickness of the oxide layer is less than 5 angstroms. At this thickness, the oxide layer will not affect the conduction between the functional layer and the third conductive layer to prevent the oxide layer from being too thick to form an insulating separation between the device wafer and the cap wafer.

In some embodiments, a micro-electro-mechanical system sensor is provided, wherein the micro-electro-mechanical system sensor comprises a device wafer and a cap wafer, wherein the device wafer comprises a functional layer and a ground electrode located on one side of the functional layer and electrically connected to the functional layer; the cap wafer comprises a second substrate, the second substrate is bonded with the functional layer of the device wafer of the device wafer through a second dielectric layer and a third conductive layer;
wherein at least a portion of the third conductive layer passes through the second dielectric layer, the second substrate is electrically connected to the functional layer through the third conductive layer.

In some embodiments, the second dielectric layer has a through hole extending through the thickness thereof, and the third conductive layer fills the through hole to be electrically connected to the second substrate.

In some embodiments, the functional layer is a monocrystalline silicon layer, and the third conductive layer is a polycrystalline silicon layer.

In some embodiments, the device wafer comprises a first substrate;
a first dielectric layer disposed on the first substrate;
a first lead, embedded within the first dielectric layer and passes through the thickness direction of the first dielectric layer;
the ground electrode is disposed on a surface of the first dielectric layer away from the first substrate, and is electrically connected to the first substrate through the first lead.

### BENEFICIAL EFFECT

The micro-electro-mechanical system sensor and the preparation method thereof according to the embodiment of the present application can achieve batch grounding of micro-electro-mechanical system sensors and improve the shielding performance of micro-electro-mechanical system sensors.

In the embodiment of the present application, the third conductive layer electrically connected to the second substrate is formed on the cap wafer, bonded to the device wafer through the third conductive layer, and the second substrate is electrically connected to the ground electrode of the device wafer through the third conductive layer, realizing simultaneous grounding of the first substrate and the second substrate.

Further, the embodiments of the present application omit the steps of forming a conductive layer by deposition on the second substrate, lithographing the conductive layer, etching the conductive layer to form the ground electrode, and punching a wire on the ground electrode, making the manufacturing process easier and more operable.

Various aspects, features, benefits, and the like of the embodiments of the present invention will be specifically described below in combination with the accompanying drawings.

The above aspects, features, benefits, and the like of the present invention will become clearer from the following detailed description in combination with the accompanying drawings.

With reference to the following description and the accompanying drawings, particular embodiments of the present invention are disclosed in detail, indicating the manner in which the principles of the present invention may be employed. It should be understood that embodiments of the present invention are not thereby limited in scope. Within the spirit and terms of the appended claims, the embodiments of the present invention include many changes, modifications and equivalents.

Features described and/or shown for one embodiment can be used in the same or similar way in one or more other embodiments, combined with features in other embodiments, or substituted for features in other embodiments.

It should be emphasized that the term "comprises/contains" as used herein refers to the presence of a feature, whole, step or component, but does not exclude the presence or addition of one or more other features, whole, steps or components.

### BRIEF DESCRIPTION OF THE DRAWINGS

To describe technical solutions in embodiments of this application more clearly, the following briefly introduces the accompanying drawings for describing the embodiments. It is clear that the accompanying drawings in the following descriptions show merely some embodiments of this application, and a person skilled in the art may still derive other drawings from these accompanying drawings without creative efforts.
FIG. 1 illustrates a schematic diagram of a structure of a conventional micro-electro-mechanical system sensor;
FIGS. 2a to 2d illustrate cross-sectional diagrams of conventional micro-electro-mechanical system sensors at various stages of the manufacturing process;
FIG. 3 illustrates a schematic diagram of a structure of a micro-electro-mechanical system sensor, according to an embodiment of the present invention;
FIG. 4 illustrates a flowchart of a method of manufacturing a micro-electro-mechanical system sensor, according to an embodiment of the present invention;
FIGS. 5a to 5d illustrate cross-sectional diagrams of the micro-electro-mechanical system sensor at various stages of the manufacturing process, according to an embodiment of the present invention.

### EMBODIMENTS OF THE PRESENT INVENTION

The above description is only an overview of the technical solution of the present invention, in order to be able to more clearly understand the technical means of the present invention, and can be implemented in accordance with the contents of the specification, and in order to make the above and other purposes, features and advantages of the present invention can be more obvious and easy to understand, the following specially cites some embodiments and with the accompanying drawings, the following is described in detail.

In the description of the present invention, it should be noted that unless otherwise specified and limited, terms such as "set," "connect," and "attach" should be broadly interpreted. For example, it can be a fixed connection or a detachable connection, or even an integral connection. It can be a mechanical connection, an electrical connection, or a communicative connection. It can be directly connected or indirectly connected through an intermediate medium. It can refer to either internal communication between two components or the interaction between the two components. Ordinary technicians in this field can understand the specific meanings of the above-mentioned terms in the present invention based on specific circumstances.

Embodiments of the present application may be presented in various forms, some examples of which will be described below.

Wafer Direct Bonding (WDB) technology is widely used in the preparation of more and more MEMS devices, and has gradually formed the fundamental technology of micro components in leading-edge subject areas, such as: MEMS packaging, SOI device preparation, thin film transfer, and the manufacturing fields of airbag accelerometers, microfluidic components, light-emitting diodes and nonlinear optical devices. It is not only suitable for wafer bonding, but can also be used for heterogeneous bonding including silicon and many other materials. Combined with precision thinning technology, it can also be used for thin layer transfer between wafers. WDB technology has an important position in MEMS processing.

WDB technology refers to a method of tightly combining silicon wafers with silicon wafers, silicon wafers with glass or other materials through chemical and physical actions. Silicon wafer bonding is often combined with surface silicon processing and bulk silicon processing and is used in the processing technology of MEMS. Common silicon wafer bonding technologies include eutectic gold-silicon bonding, silicon/glass electrostatic bonding, silicon/silicon direct bonding, and glass solder sintering.

Bonding refers to the process flow of closely combining silicon wafers with silicon wafers, silicon wafers with glass wafers or other wafers of different materials through physical and chemical actions. In this process, energy is often added to make the atoms at the bonding interface react, form covalent bonds and combine into one, and make the interface reach a specific bonding strength.

The traditional micro-electro-mechanical system sensor usually uses silicon-oxygen bonding (that is, the bonding of the silicon oxide layer and the monocrystalline silicon layer) to achieve the bonding between the device wafer and the cap wafer. Silicon-oxygen bonding results in an insulating connection between the device wafer and the cap wafer, so that the device wafer and the cap wafer need to be grounded and connected respectively, further making the traditional micro-electro-mechanical system sensor have certain limitations. The following will be described in detail in combination with the structure and manufacturing method of the micro-electro-mechanical system sensor.

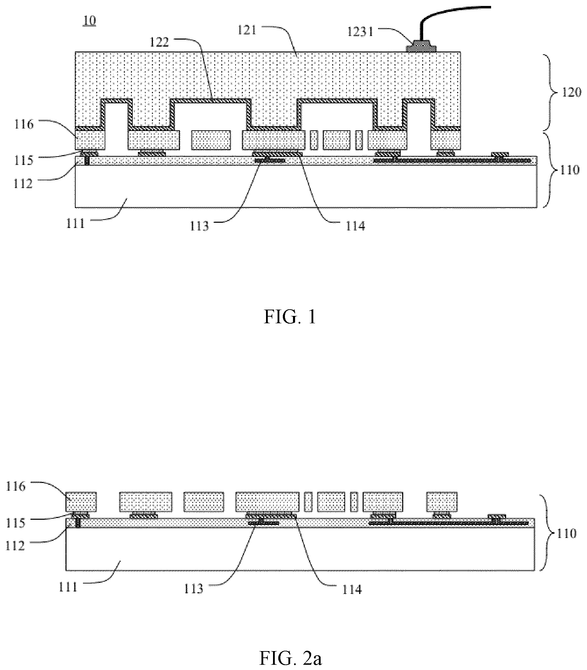

FIG. 1 illustrates a schematic diagram of a structure of a conventional micro-electro-mechanical system sensor, as shown in FIG. 1, the sensor comprises a device wafer 110 and a cap wafer 120, wherein the device 110 and the cap 120 are bonded together.

The device wafer 110 comprises a first substrate 111, a first dielectric layer 112, a lead layer 113, a first conductive layer 114, a second conductive layer 115 and a functional layer 116. The cap wafer 120 comprises a second substrate 121, a second dielectric layer 122 located on the first surface of the second substrate 121 and a ground electrode 1231 located on the second surface of the second substrate 121. The first surface and the second surface are opposite.

The cap wafer 120 is bonded to the functional layer 116 of the device wafer 110 through the second dielectric layer 122. The second dielectric layer 122 is, for example, a silicon dioxide (SiO2) layer, and the functional layer 116 is, for example, a monocrystalline silicon layer. The cap wafer 120 and the device wafer 110 are bonded together by silicon (monocrystalline silicon)-oxygen (silicon dioxide).

The ground electrode 1231 is configured to achieve the grounding of the sensor 10 to shield the sensor 10 and prevent damage to the sensor 10 caused by electromagnetic radiation and electrostatic accumulation.

FIGS. 2a to 2d illustrate cross-sectional diagrams of conventional micro-electro-mechanical system sensors at various stages of the manufacturing process, the manufacturing method of the micro-electro-mechanical system sensor according to the embodiment of the present invention will be described below with reference to FIGS. 2a to 2d.

As shown in FIG. 2a, the device wafer 110 is formed, wherein the device wafer 110 comprises a first substrate 111, a first dielectric layer 112, a lead layer 113, a first conductive layer 114, a second conductive layer 115 and a functional layer 116.

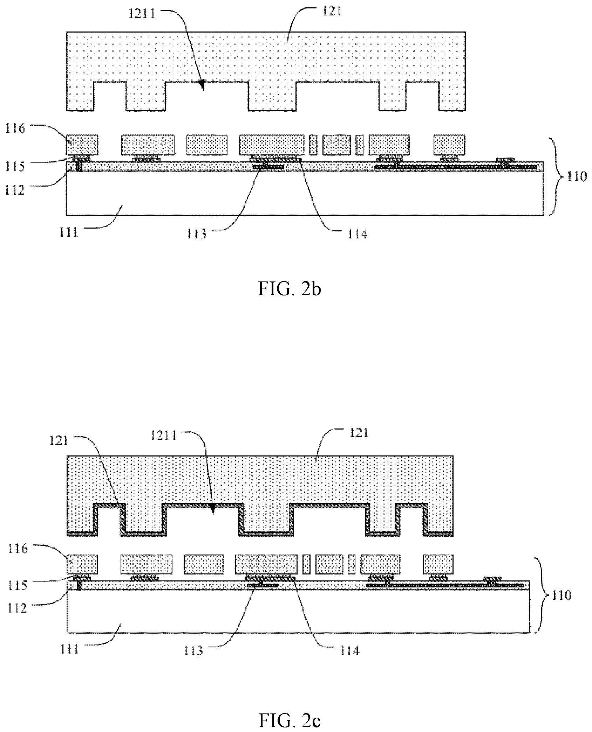

As shown in FIG. 2b, a second substrate 121 is provided, and a groove 1211 is formed on a first surface of the second substrate 121.

In this step, for example, a resist layer is formed on the first surface of the second substrate 121, the resist layer is patterned by a photolithography process to form a resist mask, and the second substrate 121 is etched through the resist mask to form the groove 1211.

As shown in FIG. 2c, for example, a second dielectric layer 122 is formed on the first surface of the second substrate 121 by deposition. Among them, the second dielectric layer 122 covers the first surface of the second substrate 121 and the bottom and side walls of the groove 1211. The second dielectric layer 122 is, for example, silicon dioxide (SiO₂).

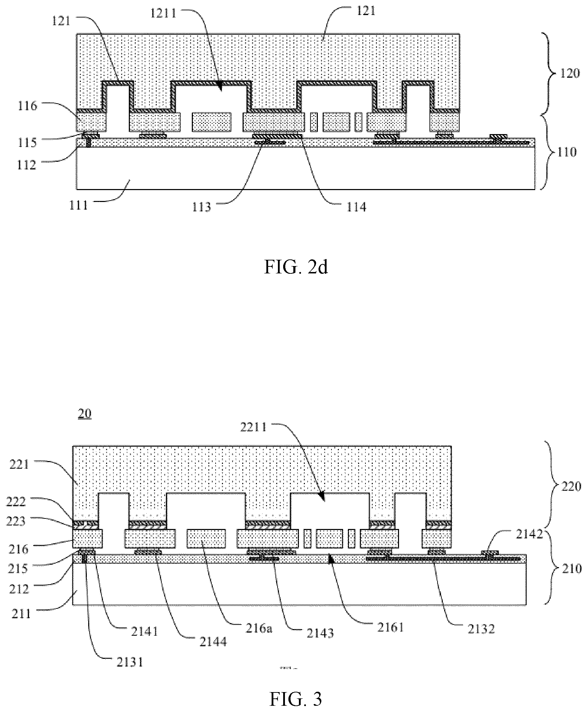

As shown in FIG. 2d, the device wafer and the cap are bonded together. Among them, the second dielectric layer 122 (SiO₂) and the functional layer 116 (monocrystalline silicon) are the bonding main bodies to realize silicon-oxygen bonding.

Further, a third conductive layer is formed on the second surface of the second substrate 121, and the third conductive layer is etched to form a ground electrode 1231. The ground electrode 1231 is connected to a wire to achieve the grounding connection of the micro-electro-mechanical system sensor, as shown in FIG. 1.

In this step, for example, a third conductive layer is formed on the second surface of the second substrate 121 by deposition, a resist layer is formed on the surface of the third conductive layer away from the second substrate 121, the resist layer is patterned by a photolithography process to form a resist mask, and the third conductive layer is etched through the resist mask to form the ground electrode 1231.

In this embodiment, after the device wafer 110 and the cap wafer 120 are bonded, a third conductive layer is deposited on the second surface of the second substrate 121, the third conductive layer is etched to form a ground electrode 1231, and wires are bonded on the ground electrode 1231. The process of forming the ground electrode 1231 above is complicated, which is not conducive to the improvement of mass production efficiency and the reduction of cost; and the reliability is low.

FIG. 3 illustrates a schematic diagram of a structure of a micro-electro-mechanical system sensor, according to an embodiment of the present invention, as shown in FIG. 3, the sensor 20 comprises a device wafer 210 and a cap wafer 220 bonded together. Among them, the device wafer 210 comprises a first substrate 211, a first dielectric layer 212, a lead layer, a first conductive layer, a second conductive layer 215 and a functional layer 216.

The first dielectric layer 212 is disposed on the first substrate 211, and the lead layer is embedded within the first dielectric layer 212. The lead layer comprises a first lead 2131 and a second lead 2132. In this regard, the first lead 2131 passes through the thickness of the first dielectric layer 212. The first lead 2131 is in contact with the first substrate 211 on the side close to the first substrate 211 to form a conductive connection with the first substrate 211. The first lead 2131 is in contact with the first conductive layer (specifically the ground electrode 2141) on the side far from the first substrate 211 to form a conductive connection with the first conductive layer (specifically the ground electrode 2141); the second lead wire 2132 is separated from the first substrate 211 on the side close to the first substrate 211 and is electrically isolated from the first substrate 211 through the first dielectric layer 212; the second lead 2132 is in contact with the first conductive layer (specifically an external electrode 2142 and/or a connection electrode 2143) on the side far from the first substrate 211 to form an electrical connection with the first conductive layer (specifically the external electrode 2142 and/or the connection electrode 2143).

In this embodiment, the first dielectric layer 212 is an insulating layer which is configured to support the lead layer and the first conductive layer, and achieving electrical isolation between the lead layer (specifically the second lead 2132) and the first conductive layer and the first substrate 211. The first substrate 211 is, for example, a silicon substrate; the first dielectric layer 212 is, for example, an inorganic insulating layer such as SiO₂, SiN or Al₂O₃, for example, a silicon dioxide (SiO₂) layer.

The first lead 2131 connects the first substrate 211 to the ground electrode 2141 to realize the grounding connection of the first substrate 211; the second lead 2132 interconnects the connection electrode 2143 or electrically connects the connection electrode 2143 and the external electrode 2142. The lead layer is, for example, one or more of conductive material layers such as aluminum, germanium, zinc, gold, and indium.

The first conductive layer is located on the surface of the first dielectric layer 212 away from the first substrate 211; the first conductive layer is etched to form the ground electrode 2141, the external electrode 2142, the connection electrode 2143 and a support electrode 2144 that are separated from each other. In this regard, the ground electrode 2141 is electrically connected to the first substrate 211 through the first lead 2131, the support electrode 2144 is located on the surface of the first dielectric layer 212 and is electrically isolated from the first substrate 211 and the lead layer inside the first dielectric layer 212 through the first dielectric layer 212; the connection electrode 2143 is electrically connected to the second lead 2132 in the first dielectric layer 212; the external electrode 2142 is electrically connected to one or more of the connection electrodes 2143 through the second lead 2132 in the first dielectric layer 212.

The second conductive layer 215 is located on the surface of the first conductive layer. The second conductive layer 215 is configured to achieve sealing and electrical connection between the functional layer 216 and the first conductive layer.

In this embodiment, the first conductive layer and the second conductive layer are, for example, one or morel of conductive material layers such as aluminum, germanium, zinc, gold, and indium.

The functional layer 216 is located on the second conductive layer 215. The functional layer 216 is etched to form a mass. The partial first conductive layer and the second conductive layer 215 under the mass are removed to form a cavity 2161, at the same time, the mass is released to form a movable mass 216a. When the movable mass 216a generates a displacement, the spacing between it and the sidewall electrode changes, so that the capacitance signal in the X/Y axis direction can be detected to realize the detection of inertia. In this embodiment, the functional layer 216 is, for example, a monocrystalline silicon layer.

The cap wafer 220 comprises a second substrate 221, a second dielectric layer 222, disposed on a first surface of the second substrate 221, and a third conductive layer 223, disposed on a surface of the second dielectric layer 222.

In this regard, the second dielectric layer 222 comprises a through hole which passes through the thickness direction of the second dielectric layer 222, that is, the first surface of the second substrate 221 is exposed through the through hole. The third conductive layer 223 covers the surface of the second dielectric layer 222 and fills the through hole on the second dielectric layer 222, the third conductive layer 223 is in contact with the first surface of the second substrate 221 through the through hole, so as to realize the electrical connection between the third conductive layer 223 and the second substrate 221.

In this regard, the cross-sectional shape of the through hole is any one of circular, elliptical, polygonal, annular and irregular shapes.

In this embodiment, the second substrate 221 is, for example, a silicon substrate, the second dielectric layer 222 is, for example, an inorganic insulating layer such as SiO₂, SiN or Al₂O₃, and the third conductive layer 223 is, for example, a polycrystalline silicon layer.

The cap wafer 120 is bonded to the functional layer 216 of the device wafer 210 through the third conductive layer 223. Bonding between polycrystalline silicon and monocrystalline silicon is realized between the third conductive layer 223 and the functional layer 216, so that the second substrate 221 can be electrically connected to the ground electrode 2141 through the third conductive layer 223, the functional layer 216, and the second conductive layer 215, at the same time, the first substrate 211 can be electrically connected to the ground electrode 2141 through the lead layer (specifically the first lead 2131), thus, the grounding connection of the first substrate 211 and the second substrate 221 is realized to shield the sensor 20 and prevent damage to the sensor 20 caused by electromagnetic radiation and electrostatic accumulation.

In some embodiments, referring to FIG. 3, the micro-electro-mechanical system sensor provided by the embodiment of the present invention includes a device wafer 210 and a cap wafer 220, wherein the device wafer 210 comprises a functional layer 216 and a ground electrode 2141 located on one side of the functional layer 216 and electrically connected to the functional layer 216; the cap wafer 220 comprises a second substrate 221. The second substrate 221 and the functional layer 216 of the device wafer 210 are bonded through a second dielectric layer 222 and a third conductive layer 223; wherein at least a portion of the third conductive layer 223 passes through the second dielectric layer 222, and the second substrate 221 is electrically connected to the functional layer 216 through the third conductive layer 223.

The second dielectric layer 222 comprises a through hole which passes through the thickness direction of the second dielectric layer 222, the third conductive layer 223 fills the through hole 2221 to electrically connect with the second substrate 221.

The functional layer 216 is a monocrystalline silicon layer, and the third conductive layer 223 is a polycrystalline silicon layer.

The device wafer 210 comprises a first substrate 211,
a first dielectric layer 212 disposed on the first substrate 211;
a first lead 2131, is embedded within the first dielectric layer 212 and passes through the thickness direction of the first dielectric layer 212;
the ground electrode 2141 is disposed on a surface of the first dielectric layer 212 away from the first substrate 211, and is electrically connected to the first substrate 211 through the first lead 2131.

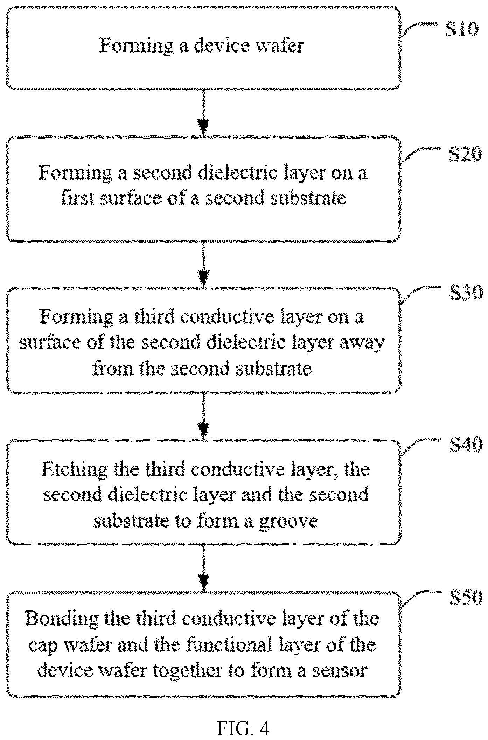

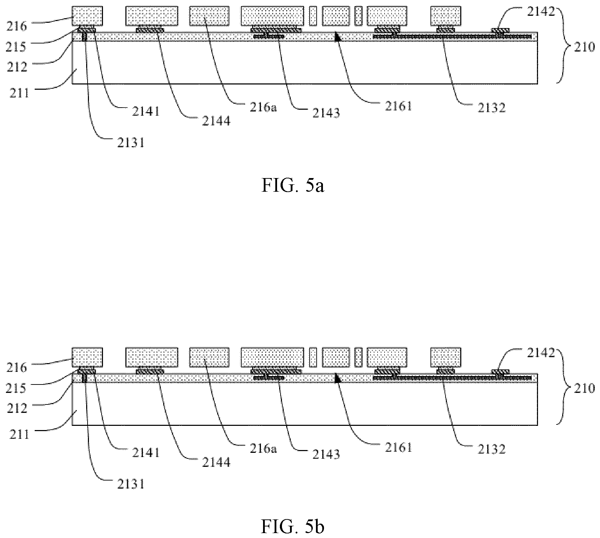

FIG. 4 illustrates a flowchart of a method of manufacturing a micro-electro-mechanical system sensor, according to an embodiment of the present invention, FIGS. 5a to 5d illustrate cross-sectional diagrams of the micro-electro-mechanical system sensor at various stages of the manufacturing process, according to an embodiment of the present invention, the method of manufacturing the micro-electro-mechanical system sensor of an embodiment of the present invention will be described with reference to FIG. 4 and FIGS. 5a to 5d.

Step S10: Forming the device wafer 210.

As shown in FIG. 5a, the device wafer 210 comprises a first substrate 211, a first dielectric layer 212, a lead layer, a first conductive layer, a second conductive layer 215 and a functional layer 216.

The first dielectric layer 212 is disposed on the first substrate 211, and the lead layer is embedded within the first dielectric layer 212. The lead layer comprises a first lead 2131 and a second lead 2132. In this regard, the first lead 2131 passes through the thickness of the first dielectric layer 212. The first lead 2131 is in contact with the first substrate 211 on the side close to the first substrate 211 to form a conductive connection with the first substrate 211. The first lead 2131 is in contact with the first conductive layer (specifically the ground electrode 2141) on the side far from the first substrate 211 to form a conductive connection with the first conductive layer (specifically the ground electrode 2141); the second lead wire 2132 is separated from the first substrate 211 on the side close to the first substrate 211 and is electrically isolated from the first substrate 211 through the first dielectric layer 212; the second lead 2132 is in contact with the first conductive layer (specifically the external electrode 2142 and/or the connection electrode 2143) on the side far from the first substrate 211 to form an electrical connection with the first conductive layer (specifically the external electrode 2142 and/or the connection electrode 2143).

In this embodiment, the first dielectric layer 212 is an insulating layer which is configured to support the lead layer and the first conductive layer, and achieving electrical isolation between the lead layer (specifically the second lead 2132) and the first conductive layer and the first substrate 211. The first substrate 211 is, for example, a silicon substrate; the first dielectric layer 212 is, for example, an inorganic insulating layer such as SiO₂, SiN or Al₂O₃, for example, a silicon dioxide (SiO₂) layer.

In this embodiment, the first dielectric layer 212 is an insulating layer which is configured to support the lead layer and the first conductive layer, and achieving electrical isolation between the lead layer (specifically the second lead 2132) and the first conductive layer and the first substrate 211. The first substrate 211 is, for example, a silicon substrate; the first dielectric layer 212 is, for example, an inorganic insulating layer such as SiO₂, SiN or Al₂O₃, for example, a silicon dioxide (SiO₂) layer.

The first conductive layer is located on the surface of the first dielectric layer 212 away from the first substrate 211; the first conductive layer is etched to form the ground electrode 2141, the external electrode 2142, the connection electrode 2143 and support electrode 2144 that are separated from each other. In this regard, the ground electrode 2141 is electrically connected to the first substrate 211 through the first lead 2131, the support electrode 2144 is located on the surface of the first dielectric layer 212 and is electrically isolated from the first substrate 211 and the lead layer inside the first dielectric layer 212 through the first dielectric layer 212; the connection electrode 2143 is electrically connected to the second lead 2132 in the first dielectric layer 212; the external electrode 2142 is electrically connected to one or more of the connection electrodes 2143 through the second lead 2132 in the first dielectric layer 212.

The second conductive layer 215 is disposed on the surface of the first conductive layer, and the second conductive layer 215 is configured to realize the sealing as well as the electrical connection between the functional layer 216 and the first conductive layer.

In this embodiment, the first conductive layer and the second conductive layer are, for example, one or morel of conductive material layers such as aluminum, germanium, zinc, gold, and indium.

The functional layer 216 is located on the second conductive layer 215. The functional layer 216 is etched to form a mass. The partial first conductive layer and the second conductive layer 215 under the mass are removed to form a cavity 2161, at the same time, the mass is released to form a movable mass 216a. When the movable mass 216a generates a displacement, the spacing between it and the sidewall electrode changes, so that the capacitance signal in the X/Y axis direction can be detected to realize the detection of inertia. In this embodiment, the functional layer 216 is, for example, a monocrystalline silicon layer. In this embodiment, the functional layer 216 is, for example, a monocrystalline silicon layer.

Step S20: A second substrate 221 is provided, and a second dielectric layer 222 with a through hole is formed on a first surface of the second substrate 221.

As shown in FIG. 5b, for example, a second dielectric layer 222 is formed on the first surface of the second substrate 221 by deposition; a resist layer is formed on the first surface of the second dielectric layer 222, the resist layer is patterned by a photolithography process to form a resist mask, and the second dielectric layer 222 is etched through the resist mask to form a through hole 2221, the first surface of the second substrate 221 is exposed through the through hole 2221.

In this regard, the cross-sectional shape of the through hole is any one of circular, elliptical, polygonal, annular and irregular shapes.

The second substrate 221 is a semiconductor substrate, such as a silicon substrate, and the second dielectric layer 222 is an insulating layer, such as SiO₂, SiN, or Al₂O₃. In a specific embodiment, the second substrate 221 is a silicon substrate and the second dielectric layer is a SiO₂ layer.

Step S30: Forming a third conductive layer 223 on a surface of the second dielectric layer 222 away from the second substrate 221.

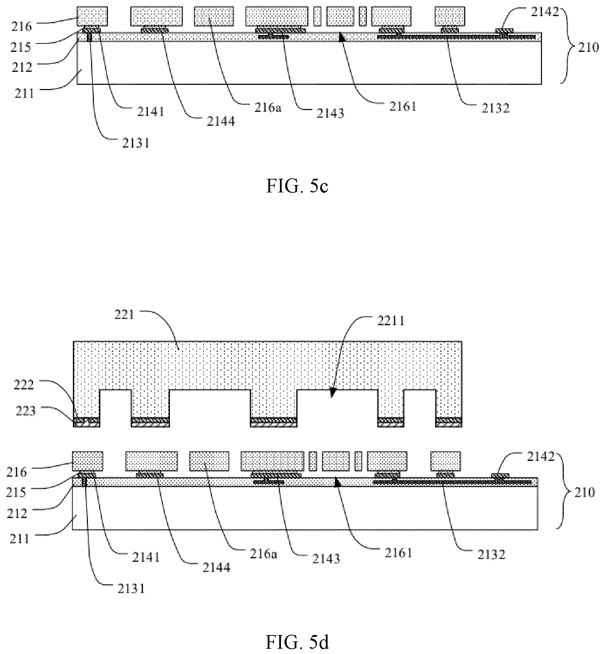

As shown in FIG. 5c, the third conductive layer 223 is formed, for example, by depositing on the surface of the second dielectric layer 222 away from the second substrate 221. Among them, the third conductive layer 223 covers the surface of the second dielectric layer 222 away from the second substrate 221 and fills the through hole 2221 and is in contact with the first surface of the second substrate 221 through the through hole 2221.

After the third conductive layer 223 is deposited and formed, the surface of the third conductive layer 223 away from the second dielectric layer 222 is chemical mechanical planarization (CMP) to obtain a smooth and flat surface on the side of the third conductive layer 223 away from the second dielectric layer 222.

In this embodiment, the third conductive layer 223 is a polycrystalline silicon layer. On the one hand, polycrystalline silicon realizes a conductive connection with the second substrate 221 through the through hole 2221, and on the other hand, it is used as a bonding layer to bond with the device wafer 210.

Step S40: Etching the third conductive layer 223, the second dielectric layer 222 and the second substrate 221 to form a groove 2211.

As shown in FIG. 5d, a resist layer is formed on the surface of the third conductive layer 223 away from the second dielectric layer 222. The resist layer is patterned by a photolithography process to form a resist mask, and the third conductive layer 223, the second dielectric layer 222 and the second substrate 221 are etched through the resist mask to form a groove 2211. After the device wafer 210 and the cap wafer 220 are bonded, the groove 2211 forms a cavity for the mass to move.

Step S50: Bonding the third conductive layer 223 of the cap wafer 220 with the functional layer 216 of the device wafer 210 together, so as to form the sensor 20 as shown in FIG. 3.

In this step, first, the surface of the functional layer 216 and the surface of the third conductive layer 223 are wet-activated. Specifically, an oxide layer is formed on the surface of the functional layer 216 and the surface of the third conductive layer 223 of the cap wafer 220 respectively, and the oxide layer serves as a medium layer for subsequent bonding.

In this embodiment, for example, an oxide layer is formed on the surface of the functional layer 216 and the surface of the third conductive layer 223 by a wet cleaning process. During the cleaning process, the cleaning solution oxidizes the surface of the functional layer 216 (monocrystalline silicon) and the surface of the third conductive layer 223 (polycrystalline silicon), and then an oxide layer is formed on the surface of the functional layer 216 and the surface of the third conductive layer 223, the oxide layer serves as a medium layer for subsequent bonding.

In a specific embodiment, the thickness of the oxide layer is less than 5 angstroms, at this thickness, the oxide layer will not affect the conduction between the functional layer 216 and the third conductive layer 223, and prevent an excessively thick oxide layer from forming an insulating isolation between the functional layer 216 and the third conductive layer 223.

Further, the third conductive layer 223 of the cap wafer 220 and the functional layer 216 of the device wafer 210 are pre-bonded.

During the pre-bonding process, the surfaces of the functional layer 216 and the third conductive layer 223 are bonded together, and a large number of hydroxyl groups or H₂O molecules are suspended on the surface of the oxide layers on the surface of the functional layer 216 and the third conductive layer 223. When the surfaces of the functional layer 216 and the third conductive layer 223 are bonded together, the hydroxyl groups form a stable H-O...H hydrogen bond structure through the bridging of water molecules, that is, the surfaces of the functional layer 216 and the third conductive layer 223 are adsorbed together by van der Waals forces.

Further, the bonded cap wafer 220 and device wafer 210 are annealed, so far, the bonding of the cap wafer 220 and the device wafer 210 is completed. Specifically, the annealing temperature is, for example, 900°C to 1200°C, and the annealing time is, for example, 20 min to 50 min.

In this embodiment, the bonding main bodies are the functional layer 216 (monocrystalline silicon) and the third conductive layer 223 (polycrystalline silicon), thereby realizing silicon-silicon bonding. In the embodiment of the present invention, through the bonding between the third conductive layer 223 and the functional layer 216, the grounding connections of the first substrate 211 and the second substrate 221 are realized at the same time, which can realize the batch grounding of the sensor 20; at the same time, the grounding connections of the second substrate and the first substrate are firm and stable, improving the reliability of the device.

Further, the embodiments of the present application omit the steps of forming a conductive layer by deposition on the second substrate, lithographing the conductive layer, etching the conductive layer to form the ground electrode, and punching a wire on the ground electrode, making the manufacturing process easier and more operable.

Further, an oxide layer is formed on the surface of the functional layer and the third conductive layer, and the thickness of the oxide layer is less than 5 angstroms. At this thickness, the oxide layer will not affect the conduction between the functional layer and the third conductive layer to prevent the oxide layer from being too thick to form an insulating separation between the device wafer and the cap wafer.

In accordance with embodiments of the invention such as the above, these embodiments are not an exhaustive recitation of all details and do not limit the invention to specific embodiments only. Obviously, many modifications and variations are possible in light of the above description. These embodiments are selected and described in detail in this specification to better explain the principles and practical applications of the present invention, so that those skilled in the art can make good use of the present invention and make modifications based on the present invention. The present invention is only limited by the claims and their full scope and equivalents.

## Claims

1. A micro-electromechanical system sensor, wherein the micro-electromechanical system sensor comprises a device wafer (210) and a cap wafer (220), wherein the device wafer (210) comprises:
a ground electrode (2141);
a functional layer (216), the functional layer (216) is electrically connected to the ground electrode (2141);
the cap wafer (220) comprises:
a second substrate (221);
a second dielectric layer (222), disposed on a first surface of the second substrate (221); and
a third conductive layer (223), disposed on a surface of the second dielectric layer (222) away from the second substrate (221), at least a portion of the third conductive layer (223) passes through the second dielectric layer (222) to be electrically connected to the second substrate (221);
a surface of the third conductive layer (223) away from the second dielectric layer (222) is bonded to the functional layer (216), the second substrate (221) is electrically connected to the ground electrode (2141) through the third conductive layer (223) and the functional layer (216).

2. The micro-electromechanical system sensor according to claim 1, wherein the second dielectric layer (222) comprises a through hole (2221), the through hole (2221) exposes the first surface of the second substrate (221); the third conductive layer (223) fills the through hole (2221) and is electrically connected to the second substrate (221) through the through hole (2221).

3. The micro-electromechanical system sensor according to claim 2, wherein the cross-sectional shape of the through hole (2221) is any one of circular, elliptical, polygonal, annular and irregular shapes.

4. The micro-electromechanical system sensor according to claim 1, wherein the device wafer (210) comprises a second conductive layer (215), the second conductive layer (215) is located between the ground electrode (2141) and the functional layer (216), and is electrically connected to the ground electrode (2141) and the functional layer (216), respectively.

5. The micro-electromechanical system sensor according to claim 1, wherein the device wafer (210) comprises:
a first substrate (211);
a first dielectric layer (212) disposed on the first substrate (211);
a first lead (2131), is embedded within the first dielectric layer (212) and passing through the thickness direction of the first dielectric layer (212);
the ground electrode (2141) is disposed on a surface of the first dielectric layer (212) away from the first substrate (211), and is electrically connected to the first substrate (211) through the first lead (2131).

6. The micro-electromechanical system sensor according to claim 1, wherein the functional layer (216) is a monocrystalline silicon layer, and the third conductive layer (223) is a polycrystalline silicon layer.

7. A preparation method of a micro-electromechanical system sensor, wherein the method comprises:
forming a device wafer (210), the device wafer (210) comprises a ground electrode (2141) and a functional layer (216) electrically connected to the ground electrode (2141);
forming a second dielectric layer (222) on a first surface of a second substrate (221);
forming a third conductive layer (223) on a surface of the second dielectric layer (222) away from the second substrate (221), at least a portion of the third conductive layer (223) passes through the second dielectric layer (222) to be electrically connected to the second substrate (221); and
bonding the third conductive layer (223) with the functional layer (216), the second substrate (221) is electrically connected to the ground electrode (2141) through the third conductive layer (223) and the functional layer (216).

8. The preparation method of a micro-electromechanical system sensor according to claim 7, wherein before forming the third conductive layer (223), the method comprises forming a through hole (2221) on the second dielectric layer (222), the through hole (2221) exposes the first surface of the second substrate (221), the third conductive layer (223) fills the through hole (2221) and is electrically connected to the second substrate (221) through the through hole (2221).

9. The preparation method of a micro-electromechanical system sensor according to claim 8, wherein the cross-sectional shape of the through hole (2221) is any one of circular, elliptical, polygonal, annular and irregular shapes.

10. The preparation method of a micro-electromechanical system sensor according to claim 7, wherein the method of forming the device wafer (210) comprises forming a second conductive layer (215) between the ground electrode (2141) and the functional layer (216), the second conductive layer (215) is electrically connected to the ground electrode (2141) and the functional layer (216) respectively.

11. The preparation method of a micro-electromechanical system sensor according to claim 7, wherein the method of forming the device wafer (210) comprises:
forming a first dielectric layer (212) on the first substrate (211);
forming a first lead (2131), the first lead (2131) is embedded within the first dielectric layer (212) and passes through the thickness direction of the first dielectric layer (212);
forming the ground electrode (2141) on a surface of the first dielectric layer (212) away from the first substrate (211), the ground electrode (2141) is electrically connected to the first substrate (211) through the first lead (2131).

12. The preparation method of a micro-electromechanical system sensor according to claim 7, wherein the functional layer (216) is a monocrystalline silicon layer, and the third conductive layer (223) is a polycrystalline silicon layer.

13. The preparation method of a micro-electromechanical system sensor according to claim 7, wherein the method of bonding the third conductive layer (223) with the functional layer (216) comprises:
performing wet activation on the surfaces of the functional layer and the third conductive layer;
pre-bonding the functional layer (216) with the third conductive layer (223);
annealing the cap wafer (220) and the device wafer (210) fitted together.

14. The preparation method of a micro-electromechanical system sensor according to claim 13, wherein in the step of performing wet activation of the surfaces of the functional layer (216) and the third conductive layer (223), an oxide layer is respectively formed on the surfaces of the functional layer (216) and the third conductive layer (223).

15. The preparation method of a micro-electromechanical system sensor according to claim 14, wherein the thickness of the oxide layer is less than 5 angstroms.

16. The preparation method of a micro-electromechanical system sensor according to claim 13, wherein during the process of annealing the cap wafer (220) and the device wafer (210) fitted together, the annealing temperature is 900°C~1200°C, the annealing time is 20min~50min.

17. A micro-electro-mechanical system sensor, wherein the micro-electro-mechanical system sensor comprises a device wafer (210) and a cap wafer (220), wherein the device wafer (210) comprises a functional layer (216) and a ground electrode (2141) located on one side of the functional layer (216) and electrically connected to the functional layer (216); the cap wafer (220) comprises a second substrate (221), the second substrate (221) is bonded with the functional layer (216) of the device wafer (210) through a second dielectric layer (222) and a third conductive layer (223);
wherein at least a portion of the third conductive layer (223) passes through the second dielectric layer (222), the second substrate (221) is electrically connected to the functional layer (216) through the third conductive layer (223).

18. The micro-electro-mechanical system sensor according to claim 17, wherein the second dielectric layer (222) comprises a through hole (2221) which passes through the thickness thereof, the third conductive layer (223) fills the through hole (2221) to electrically connect with the second substrate (221).

19. The micro-electro-mechanical system sensor according to claim 17, wherein the functional layer (216) is a monocrystalline silicon layer, and the third conductive layer (223) is a polycrystalline silicon layer.

20. The micro-electro-mechanical system sensor according to claim 19, wherein the device wafer (210) comprises:
a first substrate (211),
a first dielectric layer (212) disposed on the first substrate (211);
a first lead (2131), embedded within the first dielectric layer (212) and passes through the thickness direction of the first dielectric layer (212);
the ground electrode (2141) is disposed on a surface of the first dielectric layer (212) away from the first substrate (211), and is electrically connected to the first substrate (211) through the first lead (2131).
